# FASCICULE DE BREVET EUROPEEN

(11) **EP 1 557 394 B1**
(45) Date de publication et mention de la délivrance du brevet: **24.03.2010**
(21) Numéro de dépôt: 05100341.6
(22) Date de dépôt: 20.01.2005
(51) Int. Cl.: B81B 7/00

(54) **Dispositif et procédé pour assurer l'herméticité d'une cavité dans laquelle débouche un passage**
Vorrichtung und Verfahren zur Sicherung der Dichtheit eines Hohlraumes, in die eine Durchführungsöffnung mündet
Apparatus and method for securing hermeticity of a cavity in which a passage ends

(30) Priorité: 22.01.2004 FR 0450118
(43) Date de publication de la demande: 27.07.2005
(73) Titulaire: COMMISSARIAT A L'ENERGIE ATOMIQUE, 75015 Paris (FR)
(72) Inventeur: BALERAS, François, 38170, SEYSSINET (FR); PARAT, Guy, 38640, CLAIX (FR); COBBE, Alexandra, 38100, GRENOBLE (FR); BRUNET-MANQUAT, Catherine, 38610, GIERES (FR)
(74) Mandataire: Poulin, Gérard

(56) Documents cités:
- EP-A- 1 070 677
- WO-A-94/28581

## Description

### DOMAINE TECHNIQUE

La présente invention concerne l'herméticité de systèmes classiques de microtechnologie comprenant des empilements de couches de matériau avec des cavités intérieures hermétiques. L'invention trouve en particulier son application dans le domaine de l'assemblage de dispositifs microtechnologiques, éventuellement couplé à leur connectique et la mise en boîtier de leurs composants, domaine plus communément connu sous le nom anglo-saxon de « packaging ».

Plus particulièrement, l'invention a pour objet l'herméticité des cavités en présence d'un passage, ou « via », débouchant dans une de ces cavités après avoir traversé l'un des éléments, électroniques ou optiques ou optoélectroniques ou micromécaniques par exemple, la délimitant.

### ETAT DE LA TECHNIQUE ANTERIEURE

Les composants microélectroniques sont déposés sur des substrats en couches minces. Ces composants sont très sensibles et ils sont protégés de l'environnement soit par un produit encapsulant, soit en les plaçant dans une cavité à atmosphère contrôlée.

On entend par cavité à atmosphère contrôlée aussi bien une cavité dans laquelle est établi un vide qu'une cavité contenant un gaz de composition et/ou de pression contrôlée. Une telle cavité, définie par exemple par un capot reporté sur un substrat, peut comporter des composants sensibles tels que des composants électroniques, ou optiques, ou microélectroniques, ou optoélectroniques ou des composants de micromécanique.

Parmi les différentes techniques permettant de sceller un capot sur un support, on peut citer par exemple le scellement par verre, le scellement de type métal sur métal ou encore le scellement anodique. L'étanchéité est certes de très bonne qualité pour ces trois techniques, cependant elles nécessitent une bonne planéité et/ou une très faible rugosité des surfaces, ainsi qu'un recuit à des températures souvent élevées (400 à 1100°C). Pour pallier cet inconvénient, il a été proposé d'utiliser des brasures pour le scellement, comme le montrent par exemple les documents US-A-3 657 610 ou WO 94/28581.

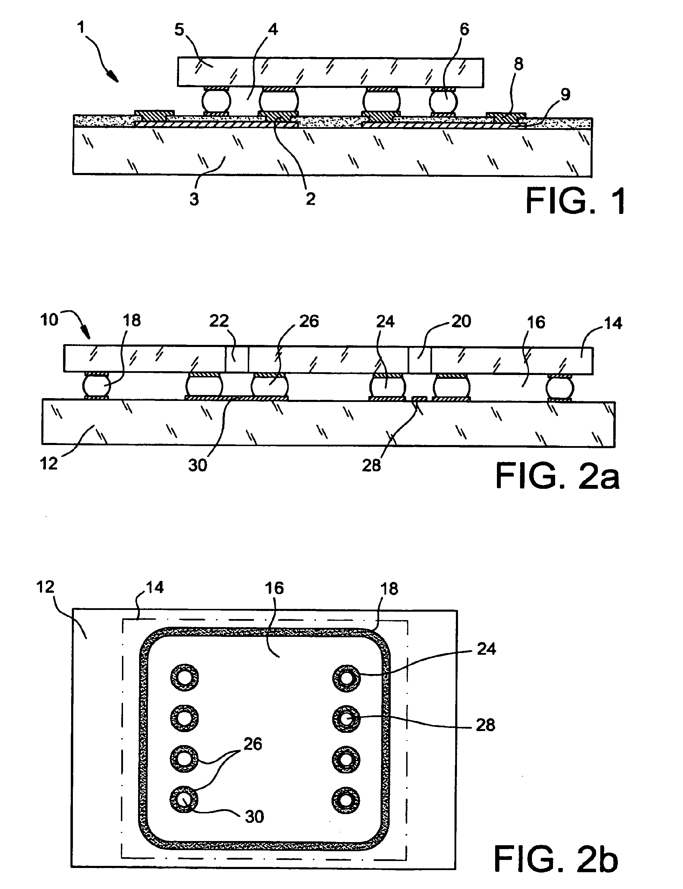

Lors de cette encapsulation cependant, la connexion des composants se fait par des pistes métalliques qui passent dans le substrat et sous le cordon de scellement pour connecter les plots internes vers des plots externes (voir figure 1). Cette technique crée des pertes résistives liées aux longueurs de lignes, ainsi que des capacités et des selfs parasites entre le scellement s'il est métallique et les pistes conductrices.

Il est donc souhaitable de raccourcir les lignes de courant afin d'éliminer les effets parasites, en positionnant par exemple des accès directs vers des plots de connexion plus proches du composant, et notamment au sein de la cavité hermétique le contenant. Par ailleurs, il est possible d'avoir certains composants électroniques qui ne nécessitent pas cette protection à atmosphère contrôlée : les accès directs permettent ainsi par exemple de tester les composants avant le montage final.

Dans ces conditions, un passage, communément appelé « via », est dégagé dans l'un des substrats, le plus souvent le capot, pour un accès direct au composant (entendu au sens large, c'est-à-dire aussi bien un plot de connexion qu'un composant électronique à proprement parler, ou un composant optique, ou optoélectronique, etc.) situé sur l'autre substrat délimitant le fond de la cavité. Cependant se pose alors le problème du contrôle de l'atmosphère dans la cavité ainsi percée et de son herméticité.

Le document EP 1 070 677 décrit un procédé de production d'un boîtier de plaquettes comprenant les étapes consistant à :
- fournir une première plaquette, une seconde plaquette et un micro-dispositif ;
- former un plot de connexion et un plot périphérique sur ladite première plaquette, ledit plot périphérique entourant ledit plot de connexion, le plot de connexion établissant le contact électrique au micro-dispositif ;
- former sur ladite seconde plaquette un premier plomb correspondant essentiellement au périmètre dudit plot de connexion et un second plomb entourant ledit premier plomb et correspondant audit plot périphérique ;
- former un puits dans ladite seconde plaquette moyennant quoi ledit puits est entouré dudit premier plomb ;
- coller ladite première plaquette et ladite seconde plaquette par soudage à froid, ledit premier plomb et ledit second plomb, ledit plot de connexion et ledit plot périphérique respectivement pour former un volume scellé hermétiquement, ladite seconde plaquette pouvant être positionnée avec ledit puits sur ledit plot de connexion, et ledit micro-dispositif dans ledit volume scellé hermétiquement (25) entre lesdits plombs; et
- éliminer une portion de ladite seconde plaquette moyennant quoi ledit puits devient un trou traversant dans ladite seconde plaquette, ledit trou traversant étant ouvert audit plot de connexion sur ladite première plaquette.

### EXPOSÉ DE L'INVENTION

La présente invention propose de remédier entre autres à ces problèmes existants d'herméticité. Sous l'un de ses aspects, la présente invention concerne un dispositif microélectronique comprenant une cavité délimitée par deux éléments au moins, par exemple un substrat et un capot, un cordon de scellement et un « via » débouchant dans cette cavité, par exemple issu d'un trou dans le capot. Le « via », ou passage, est par ailleurs délimité, entre les deux éléments, par des parois en matériau fusible qui garantissent son herméticité. Les parois peuvent par exemple être un micro cordon de soudure. Du fait de l'herméticité du passage, la cavité au sein de laquelle se trouve le via peut rester étanche et/ou hermétique : le via ainsi réalisé permet par exemple un accès direct au substrat sans perturber l'herméticité de la cavité.

La cavité est formée par les deux éléments qui sont reliés entre eux par un cordon extérieur de façon à être scellée. De façon préférée, des sous éléments tels que des composants électroniques, optiques, etc. sont disposés dans cette cavité étanche dont l'atmosphère peut être contrôlée.

Avantageusement, dans le passage libéré et sur le substrat se trouve un sous élément microtechnologique, c'est-à-dire par exemple un plot de connexion pour un composant électronique, optique, etc., ou un de ces composants. Les parois sont alors disposées de façon à délimiter un passage hermétique entre le sous élément localisé sur le substrat et l'extérieur.

La présente invention permet ainsi d'assurer l'herméticité de la cavité même en présence d'au moins un passage permettant d'accéder directement à une zone particulière de la cavité. Ces accès directs, par exemple vers des plots de connexion, améliorent les performances du composant électronique ainsi connecté grâce à une liaison directe vers l'extérieur de la cavité, par rapport aux solutions de connexions sur les bords de la cavité.

Selon un mode de réalisation, les plots de connexion peuvent être reliés au matériau fusible constituant les parois. Ceci présente l'avantage qu'il n'y a pas de piste métallique séparée passant sous le matériau fusible, et diminue donc les effets capacitifs.

De manière préférée, la connexion des sous éléments directement à l'extérieur par les passages se fait par l'intermédiaire de billes fusibles.

La présente invention concerne également un procédé de fabrication de passages hermétiques accédant à des zones particulières d'une cavité, le procédé utilisant du matériau fusible pour délimiter les zones d'étanchéité. Avantageusement, le procédé présente des étapes alternant le dépôt de couches mouillantes et non mouillantes pour dessiner la géométrie des cordons de matériau fusible.

Le procédé de fabrication permet d'aligner avec précision et/ou de sceller de façon collective un grand nombre de dispositifs de microtechnologie, comprenant par exemple des composants électroniques, ou optiques, ou optoélectroniques, ou micromécaniques, etc., tout en laissant certains des composants, totalement ou en partie, et/ou leurs plots de connexion directement accessibles selon des géométries variées. Par ailleurs, les formes des parois destinées à isoler les passages peuvent être choisies sans contraintes de fabrication.

### BRÈVE DESCRIPTION DES DESSINS

La figure 1 représente un composé électronique scellé par un cordon de soudure connu de l'état de la technique.

Les figures 2a et 2b représentent schématiquement deux vues en coupe (latérale et frontale) d'un composé électronique selon un mode de réalisation du dispositif selon l'invention.

La figure 3 montre un exemple de géométrie différente des parois d'un via.

La figure 4 représente un autre exemple de dispositif selon l'invention.

Les figures 5a-5f montrent un des modes de réalisation d'un procédé selon l'invention.

Les figures 6a, 6b, 6c montrent des exemples de connexion directe par des passages dans un dispositif selon l'invention.

### EXPOSÉ DÉTAILLÉ DE MODES DE RÉALISATION PARTICULIERS

Dans un composé électronique (1) selon l'art antérieur et tel que représenté sur la figure 1, des composants électroniques, dont seule une partie est représentée, par exemple les plots, (2) sont localisés dans un substrat (3). Une cavité hermétique (4) est formée par un deuxième élément (5) scellé sur son pourtour au substrat (3) par l'intermédiaire d'un cordon fusible (6) localisé au niveau de plages mouillantes. Afin d'assurer la connexion du composant électronique, les plots d'entrée/sortie (2), sont reliés aux plots externes (8) par des pistes métalliques (9) passant sous le cordon de scellement (6), ce qui implique des lignes de courant longues et des interférences entre le cordon (6) et les pistes métalliques, ou plaques de connexion, (9).

La cavité hermétique (4) est formée par deux éléments (3, 5), qui peuvent être choisis indifféremment, par exemple parmi les éléments suivants : un composant électronique, un substrat, un capteur, un capot,...

Des composants, électroniques dans le cas représenté, (2) sont localisés dans la cavité hermétique (4) dont l'atmosphère peut être contrôlée, par exemple par injection d'un gaz inerte sous pression contrôlée, ou par mise sous vide. Aucun contact direct n'est donc possible une fois le composé (1) fabriqué.

Pour certains composants, un accès direct est possible, voire souhaitable. Par ailleurs, un plot de connexion externe (8) plus proche du composant (2), c'est-à-dire au sein de la cavité (4), permettrait de raccourcir les lignes de connexion et d'éviter par là les effets parasites mentionnés ci-dessus. Pour avoir cet accès direct, un passage est créé dans l'élément supérieur (5), communément appelé « via ». Cependant, la création de ce passage, aussi petit soit-il, entraîne des problèmes dans l'herméticité de la cavité (4).

Les figures 2a et 2b illustrent un composé électronique selon l'un des modes de réalisation de l'invention. La description qui va suivre fera référence à un composé électronique (10), mais il faut comprendre que ce terme est employé à titre illustratif et non limitatif : dans le cadre de l'invention, il apparaîtra clairement à l'homme du métier que tout composant optique, ou optoélectronique, ou micromécanique, ou autre classique en microtechnologie peut être concerné et utilisé dans et pour un dispositif selon l'invention.

Le composé électronique (10) est constitué d'un substrat (12) et d'un capot (14). Par « capot », il faut entendre toute structure située « au-dessus » de la cavité telle que représentée sur la figure 2a, et qui peut donc être également un autre composant électronique ou optoélectronique, comme un capteur, un actionneur, ou un quelconque premier élément électronique ou optique, ou optoélectronique, voire une simple couche de matériau ; de même le terme « substrat » doit-il être entendu au sens large et peut être constitué des mêmes éléments que cités pour le capot. Une cavité (16) est ainsi créée entre le substrat (12) et le capot (14). L'herméticité extérieure de cette cavité (16), où peuvent être localisés des composants (2) de la même manière que présenté dans la figure 1, est dans le cadre de la figure 2 réalisée par un cordon (18) de soudure externe ; d'autres méthodes de scellement sont envisageables et connues de l'homme du métier.

Des trous (20, 22) sont localisés dans le capot (14) afin d'avoir un accès direct au substrat (12) et à des sous éléments tels que des plots ou tout ou partie de composants. Afin d'assurer l'herméticité de la cavité interne (16), des micro cordons de soudure (24, 26) sont disposés sur la périphérie des trous (20, 22) : ils créent des prolongements tubulaires au capot (14), dont le diamètre intérieur est similaire à celui des trous (20, 22), mais qui peut être plus grand ou plus petit tant que l'herméticité est assurée entre le capot (14), le cordon ou paroi (24, 26) et le substrat (12). On obtient ainsi la création d'un passage, plus communément appelé « via » dans le domaine de la microtechnologie, qui est hermétique.

Un sous élément tel qu'un plot de connexion (28) peut être localisé dans le passage ainsi créé par le trou (20), le micro cordon (24) étant localisé à sa périphérie : dans ce cas de figure, le sous élément (28) est isolé du micro cordon (24). Selon une autre possibilité, un sous élément tel qu'un plot de connexion (30) peut être de taille supérieure au passage final : le micro cordon de soudure (26) est alors localisé sur le pourtour de ce type de plot (30) auquel il peut éventuellement être relié électriquement ; le passage formé par le trou (22) dans le premier élément électronique (14), la paroi (26) et le plot (30) est également étanche.

Il est clair que les sous éléments (28, 30) peuvent être remplacés par d'autres composants que des plots de connexion ; on entend par composant l'ensemble des éléments utilisés en microtechnologie, c'est-à-dire principalement les composants électroniques, otiques, microélectroniques, micromécaniques, optoélectroniques, ainsi que leurs plots de connexion. Il est clair également qu'une combinaison des deux géométries présentées ci-dessus est envisageable, avec recouvrement partiel du composant électronique ou plot de connexion, tant que le trou ainsi formé reste hermétique. Ainsi par exemple, pour une résistance électrique placée sur le substrat, il est possible de n'en laisser qu'une partie accessible par l'intermédiaire d'un via (30). Il est par ailleurs à noter que, pour simplifier les schémas, les passivations ne sont pas indiquées sur la figure 2a, de même que les différents dépôts inhérents à la fabrication de ces composés électroniques et connus de la personne du métier.

Les connexions des éléments (2) situés dans les cavités (16), qui sont réalisées à l'extérieur des cavités étanches (16), peuvent être de différents types (billes ou broches) tel qu'il sera par ailleurs détaillé plus tard. Elles peuvent être, ou non, au contact des cordons de soudure (18, 24, 26).

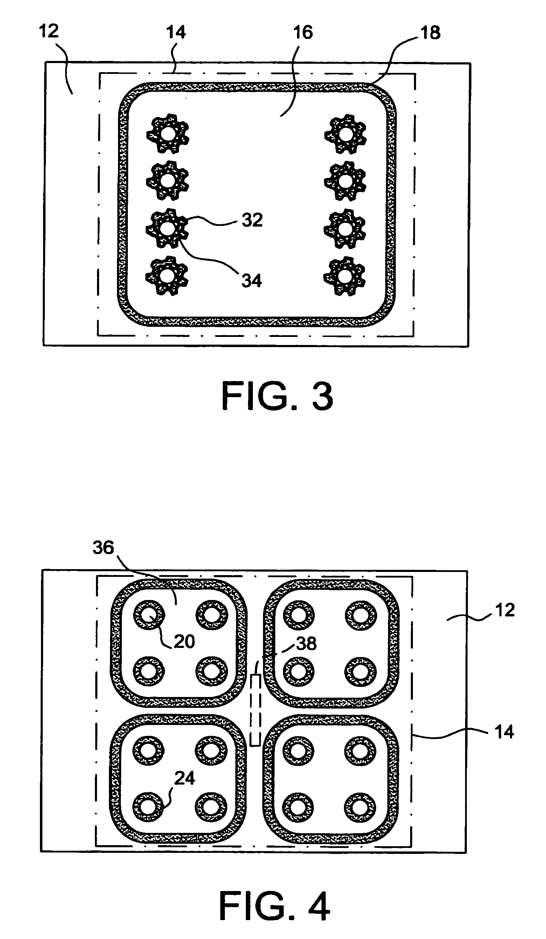

Sur les figures 2 sont présentés des vias dont les parois (24, 26) sont de sections circulaires ; ce mode de réalisation n'est qu'une alternative. Ainsi par exemple, tel que représenté sur la figure 3, il est possible de réaliser la paroi hermétique du trou à partir de billes disjointes (32). Lors de la fusion du matériau, comme il sera explicité plus loin, il y a jonction des différentes billes (32), avec une largeur des cordons (34) ainsi formé plus faible entre chaque bille, mais suffisante pour assurer la même herméticité que précédemment par le cordon annulaire régulier (24, 26). Ceci permet d'obtenir des formes plus complexes pour les cordons et les micro cordons, et permet un meilleur contrôle de la matière déposée.

En même temps que la fabrication des micro cordons, on peut réaliser aussi des billes fusibles, par exemple dans un alliage fusible identique à celui des cordons de scellement (18, 24, 26), permettant la connexion électrique entre la partie supérieure et la partie inférieure, ces billes fusibles permettant en outre de réaliser un auto alignement des éléments (12, 14). Des billes fusibles peuvent également être employées pour connecter de façon hermétique la partie supérieure de boîtier (capot comportant un élément microélectronique ou microtechnologique) avec la partie inférieure. De telles billes fusibles sont réalisées avantageusement en même temps que les micro cordons (24, 26). La présence des billes fusibles permet de conserver l'effet d'auto alignement (force de mouillabilité de matériau fusible en phase liquide) de l'élément (14) avec l'élément (12) ; cet effet d'auto alignement n'est pas indispensable, mais préférable.

Il est également possible d'avoir un ensemble composé de plusieurs cavités hermétiques (36) localisées sur le même substrat (12), tel que représenté sur la figure 4. Si l'on rajoute des accès sur le substrat, on peut aussi fabriquer des modules hermétiques par l'assemblage de plusieurs de ces ensembles, pour obtenir par exemple des « multi-chips ». Il est également possible de prévoir dans un ensemble composé tel que représenté sur la figure 4 des passages (38) extérieurs aux cavités (36) à atmosphère contrôlée afin de faciliter les connexions et de raccourcir les lignes de courant.

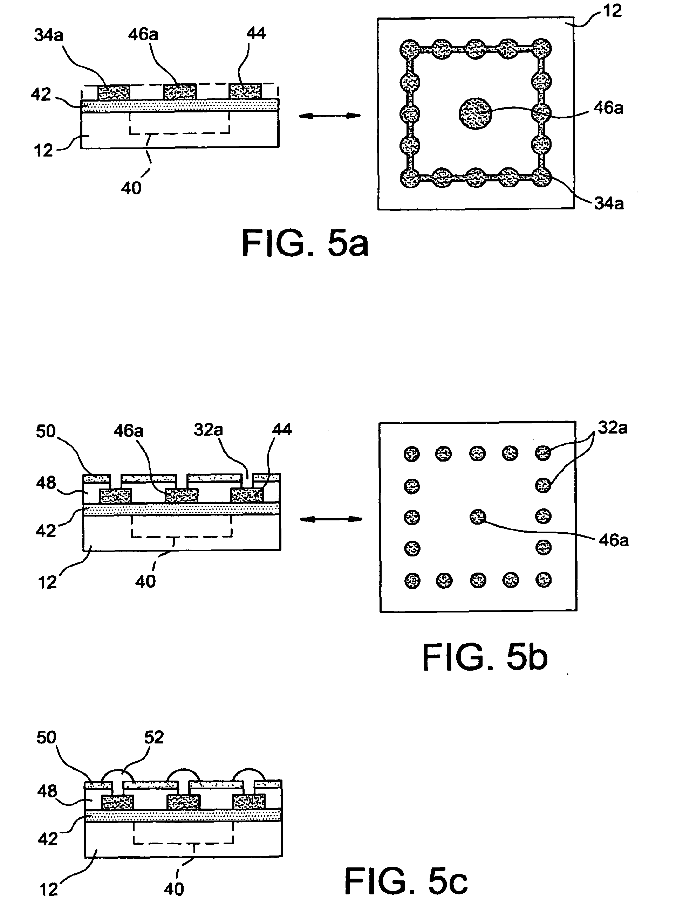

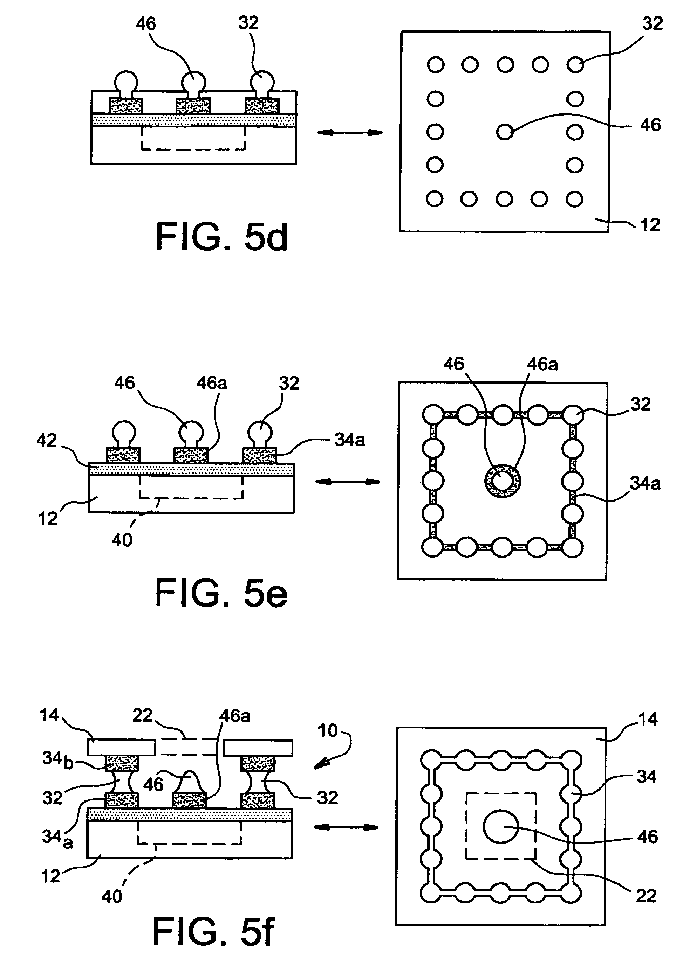

Un mode de fabrication d'un dispositif selon l'invention et schématisé sur les figures 5, débute par la mise en place selon des techniques connues (dépôt par exemple) sur un substrat (12), tel que par exemple une plaquette de matériau semiconducteur, d'un ou plusieurs composants électroniques ou microtechnologiques tels que définis plus haut, dont la surface active est par exemple telle que représentée par le signe de référence (40) sur la figure 5a. Tel qu'il l'est connu de l'homme du métier, une couche isolante (42) est ensuite déposée sur le substrat, laissant accessibles des sous éléments tels que les plots de connexion du composant (40).

Ensuite, un matériau mouillable (44) par un matériau fusible est déposé sur le matériau isolant (42) comportant les sous éléments ; le matériau mouillable est par exemple constitué d'un empilement de couches minces de type de titane, nickel ou or. Des plages d'accueil (34a, 46a) y sont formées, par exemple par photolithographie, pour les cordons de scellement externe (non représenté), les micro cordons de soudure (34) destinés à l'herméticité des vias, ainsi que pour les éventuelles connexions par billes fusibles (46) des composants (40) tel qu'il sera décrit plus tard.

De façon avantageuse, une couche non mouillante (48), conductrice ou non, est ensuite déposée au dessus de cet ensemble, par exemple du titane. Une couche de matériau sacrificiel (50), par exemple une résine, notamment photosensible, est alors déposée sur la couche non mouillante (48), afin de définir des ouvertures sur les plages d'accueil (32a, 46a) des billes fusibles, par gravure de la couche non mouillante (48) : figure 5b.

Le matériau fusible (52) est alors déposé (figure 5c) sur les surfaces mouillantes dégagées des plages d'accueil (32a, 46a). Avantageusement, le même matériau est utilisé pour le scellement externe (non représenté) et pour les parois (34) destinées à assurer l'étanchéité au niveau des passages, mais ce n'est pas une obligation ; de même, le matériau fusible utilisé pour les connexions (46) peut être différent du matériau fusible utilisé pour les cordons (18, 34) assurant l'herméticité. Il existe plusieurs méthodes de dépôt de matériaux fusibles, dont l'électrodéposition ; dans ce cas, la couche non mouillante (48) est conductrice. Le matériau fusible (52) peut être un alliage Au/Sn, Sn/Pb, Sn/Cu... ou un métal pur comme Sn.

La résine photosensible (50) est alors éliminée, par exemple par dissolution avec un solvant. Le substrat (12) est chauffé, par exemple, pour atteindre une température supérieure ou égale à la température de fusion du matériau fusible (52). Lors de la phase liquide du matériau, les tensions de surface vont provoquer la formation de billes (32, 46) ou de bossages : figure 5d. La forme dépend de la quantité de matière fusible (52) par rapport à la taille des surfaces mouillantes dégagées (32a, 46a).

Par retrait, par exemple par gravure, de la couche non mouillante (48), on libère ensuite totalement les plages d'accueil (34a, 46a) jusque là encore protégées, notamment celles destinées aux cordons (34) : figure 5e. Il reste alors à assembler le composé ainsi formé : figure 5f. Un autre élément électronique (14), par exemple choisi parmi des puces, des capots ou des substrats, est posé sur le substrat (12) comportant les bossages (32, 46). L'élément supérieur (14) possède des plages d'accueil (34b) en matériau mouillant, au moins dans les zones de l'élément supérieur (14) en regard des plages d'accueil (34a) de l'élément inférieur (12) ; il est préférable que l'élément supérieur (14) dispose des mêmes géométries de plages d'accueil que le substrat initial (12). Cet élément (14) possède dans cet exemple déjà les trous (22) destinés aux accès aux composants (40), ou ces passages peuvent être formés ensuite : de fait, les vias peuvent être formés avant ou après scellement. La réalisation de ces passages dans tous les cas peut être obtenue par des méthodes classiques en microtechnologie, par exemple par perçage laser, gravure au plasma, gravure humide anisotrope localisée aux motifs recherchés.

Le scellement de l'ensemble est obtenu en portant une deuxième fois le matériau fusible (52) à une température supérieure ou égale à sa température de fusion : le matériau fusible en phase liquide mouille le restant de la surface des plages d'accueil (34a, 46a) localisées sur le substrat (12) (et protégée auparavant par la couche anti-mouillante) ainsi que les plages d'accueil (34b) localisées sur le capot (14). Cette étape sert également à l'auto-alignement entre le substrat (12) et le capot (14).

Parallèlement, lors de la deuxième opération de fusion, on peut procéder à l'établissement de l'atmosphère interne de la cavité, non représentée sur les figures 5 (en fait, externe au trou (22)), par exemple si l'opération se déroule dans une enceinte à atmosphère contrôlée.

Ce procédé n'est indiqué qu'à titre d'exemple. Il permet entre autres une grande souplesse dans la géométrie des différentes parties du composé (10) : il apparaît clairement que la géométrie des parois de via (24, 26, 34), et similairement d'un cordon de scellement (18) dépendent du schéma gravé sur la résine (50) et la couche mouillante (42), ainsi que de la présence ou non d'une couche non mouillante (48). En particulier, il serait également possible de déposer directement un micro cordon de soudure pour former les parois (34, 18).

Les techniques utilisées pour la fabrication, et notamment les techniques de gravure et d'amincissement, permettent donc une grande liberté dans le choix de la forme et des dimensions des passages (20, 22). Par ailleurs, plutôt que de réaliser la connexion par billes fusibles (46) directement en même temps que la fabrication du dispositif (10) tel que décrit ci-dessus, il est possible de laisser la connexion du composant (40) simplement libre dans le passage créé par le trou (22) et d'assurer cette connexion ensuite, comme illustré sur les figures 2.

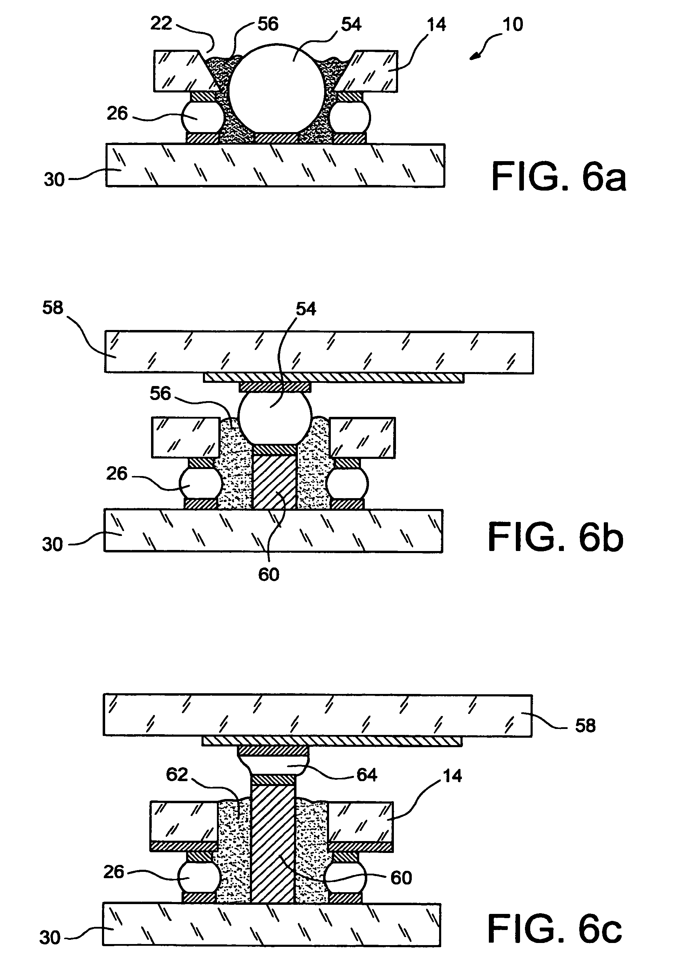

Par exemple, il est possible d'implanter des billes fusibles à l'intérieur des passages (20, 22), afin de connecter les plots (28, 30) qui s'y trouvent. Différentes méthodes de report de connexion interne du composant électronique vers l'extérieur par un passage sont illustrées dans les figures 6.

En particulier, dans la figure 6a, une bille fusible (54) est déposée directement sur le composant (30) dans le passage afin d'avoir une connexion possible sur la face supérieure de la bille (54) et du dispositif (10). Avantageusement, une résine (56) est ensuite insérée dans le trou laissé par le cordon (26) et le trou (22) du substrat (14). Dans ce cadre, il est souhaitable que le matériau fusible utilisé pour les billes externes (54) ait un point de fusion plus bas que le matériau fusible (52) pour les cordons de scellement (18, 24, 26, 34).

On obtient ces billes (54) par différentes méthodes : sérigraphie, jet, dispense d'alliage fusible.... Les billes (54) sont naturellement isolées des parois des accès (22) qui sont délimités par les parois du passage dans le capot (14) et le cordon d'étanchéité (26) ; il n'est pas donc nécessaire de déposer une couche isolante sur les parois des accès. Le rapport dimensionnel entre la taille des billes et le ratio du via donne un isolement naturel entre la bille (54) et le capot (14).

Pour une meilleure gestion de la dilatation différentielle entre le dispositif (10) et le substrat d'interconnexion (58) qui sera positionné au-dessus de la bille (54) et du dispositif (10) pour empilement éventuel, il est souhaitable de plus d'avoir une implantation des billes (54) éloignée du substrat (12). La présence d'un pilier (60) permet d'augmenter la distance entre bille (54) et substrat (12) : figure 6b.

Pour ce mode de réalisation, on peut avoir comme dimensions par exemple :

| | |
|---|---|
| largeur du composant (30) : | 120 µm |
| largeur du micro cordon (26) : | 20 µm |
| hauteur d'assemblage : | 20 µm |
| épaisseur du capot (14) : | 50 µm |
| hauteur du pilier (60) : | 50 µm |
| largeur du pilier (60) : | 40 µm |
| largeur du passage : | 80 µm |
| diamètre de la bille (54) : | 50 µm |

La connexion peut également être effectuée par l'intermédiaire d'une broche (62) soudée (64) sur le substrat d'interconnexion (58) ; dans ce cas, la connexion est standardisée : voir figure 6c.

Il est par ailleurs possible de prévoir, entre la connexion externe et le cordon de scellement, une zone non mouillante : si la connexion externe est réalisée par une bille fusible, la zone non mouillante permet de s'assurer que la bille ne vient pas en contact avec le cordon de scellement lors du brasage.

L'invention permet donc la création d'accès directs mais hermétiques à des zones localisées d'une cavité à atmosphère contrôlée contenant des composants classiques en microtechnologie, électroniques ou autres. En particulier, elle permet le contrôle de la pression du vide interne par le passage entre les billes lors de la fermeture. L'invention trouve des applications pour l'encapsulation hermétique de puces électroniques, de capteurs de pression ou d'accélération, de filtres ou de systèmes plus complexes utilisés en microtechnologie. En particulier, la topologie des substrats peut être compensée, et le procédé est également compatible avec des substrats non rigides, comme des circuits souples, des circuits imprimés, ou rigides, par exemple céramiques.

Grâce à l'invention, auto-alignement et alignement passif des deux éléments à assembler sont possibles, et un montage simultané d'un composant par la technique « flip chip » (ou puce retournée) et d'un capot peut être réalisé, les réalisations pouvant être effectuées à l'échelle de la puce ou de la tranche (« wafer ») .

L'invention permet également de monter des capots avec des hauteurs différentes : à l'échelle du wafer, les tailles de billes peuvent être variables. Il est en effet très facile pour l'homme du métier d'ajuster la taille de l'espace entre les éléments en vertical ou en horizontal, en adaptant la taille des billes et des zones mouillantes.

Par ailleurs, l'invention permet de connecter directement certains éléments par des billes de matière fusible. Ce genre de connexion peut être souhaitable notamment dans le cadre de l'assemblage d'un dispositif selon l'invention sur un circuit imprimé : les billes de connexion peuvent être reliées directement sur la partie inférieure d'un autre dispositif, par exemple en silicium, ce qui compensera mieux la différence de dilatation différentielle.

## Revendications

1. Dispositif microtechnologique (10) comprenant au moins une cavité hermétique (16, 36), cette cavité hermétique étant délimitée par au moins un cordon de scellement (18) et deux côtés composés par un premier élément (14) et un deuxième élément (12), et par au moins une paroi étanche d'au moins un passage délimité par la face intérieure du deuxième élément(12), un trou (20, 22) dans le premier élément (14) et ladite paroi, qui est en matière fusible brasée (24, 26, 34) sur des zones mouillantes du premier élément et du deuxième élément.

2. Dispositif selon la revendication 1 comprenant au moins un sous élément (28, 30) positionné sur le deuxième élément (12) et en partie au moins dans le passage délimité par la face intérieure du deuxième élément (12), ledit trou (20, 22) dans le premier élément (14) et ladite paroi.

3. Dispositif selon la revendication 2 dans lequel au moins un desdits sous éléments (28, 30) possède une connexion (46, 54, 60) vers l'extérieur passant par le passage.

4. Dispositif selon la revendication 3 dont la connexion est effectuée par l'intermédiaire d'une bille fusible (46, 54).

5. Dispositif selon la revendication 4 dans lequel la bille fusible pour la connexion (46, 54) est composée du même matériau que la ou les parois en matière fusible (24, 26, 34).

6. Dispositif salon l'une des revendications 1 à 5 comprenant en outre au moins un composant (2) dans au moins une desdites cavités hermétiques (16, 36).

7. Dispositif selon l'une des revendications 1 à 6 dont les premier et/ou deuxième éléments (12, 14) sont choisis parmi un substrat, un substrat non rigide, un capot, un capteur, un composant électronique, un composant optoélectronique, un actionneur.

8. Dispositif selon l'une des revendications 1 à 7, comportant une pluralité de parois étanches, correspondant à une pluralité de passages, chacun étant délimité par la face intérieure du deuxième élément, un trou (20, 22) dans le premier élément (14) et une ou plusieurs parois.

9. Module comprenant une pluralité de dispositifs selon l'une des revendications 1 à 8.

10. Procédé de fabrication d'un dispositif microtechnologique comportant un premier et un deuxième élément comprenant au moins un passage aux parois étanches, comprenant les étapes de :
- mise en place sur ledit deuxième élément (12) de zones mouillantes (34a), destinées au moins en partie à réaliser des parois (24, 26) étanches dudit passage ;
- dépôt sur des zones mouillantes (34a) de première matière fusible (52) et de deuxième matière fusible ;
- positionnement dudit premier élément (14) au-dessus de la première matière fusible, de la deuxième matière fusible et du deuxième élément (12) ;
- scellement par brasage de l'ensemble formé par les deux éléments (12, 14), la première matière fusible (52) et la deuxième matière fusible de sorte que au moins un espace étanche soit créé, délimité par les deux éléments (12, 14) et au moins une paroi de première matière fusible (24, 26) et qu'une cavité hermétique soit délimitée par au moins un cordon de scellement (18) en deuxième matière fusible et deux côtés composés par le premier élément (14) et le deuxième élément (12), et au moins une paroi de première matière fusible,
- création d'au moins un trou (20, 22) dans le premier élément (14) en face d'au moins un espace étanche défini par les parois de première matière fusible (24, 26) pour obtenir le passage aux parois étanches.

11. Procédé de fabrication d'un dispositif microtechnologique comportant un premier et un deuxième élément et comprenant au moins un passage aux parois étanches, comprenant les étapes de :
- mise en place sur ledit deuxième élément (12) de zones mouillantes (34a), destinées au moins en partie à réaliser des parois (24, 26) étanches dudit passage ;
- dépôt sur des zones mouillantes (34a) de première matière fusible (52) et de deuxième matière fusible ;
- positionnement dudit premier élément (14) au-dessus de la première matière fusible (52), de la deuxième matière fusible et du deuxième élément (12), le premier élément (14) comprenant au moins un trou (20, 22) débouchant ;
- scellement par brasage de l'ensemble formé par les deux éléments (12, 14) et la première matière fusible (52) et la deuxième matière fusible de sorte que le passage délimité par le trou débouchant (20, 22) du premier élément (14), le deuxième élément (12) et au moins une paroi de première matière fusible (24, 26) soit à paroi étanche, et qu'une cavité hermétique soit délimitée par au moins un cordon de scellement (18) en deuxième matière fusible et deux côtés composés par le premier élément (14) et le deuxième élément (12), et au moins une paroi de première matière fusible.

12. Procédé selon l'une des revendications 10 ou 11 dans lequel la première matière fusible est identique à la deuxième matière fusible.

13. Procédé selon l'une des revendications 10 à 12 dans lequel le dépôt de matière fusible est un dépôt localisé d'alliage fusible suivi de la formation de billes de matière fusible par fusion.

14. Procédé selon la revendication 13 comprenant, préalablement au dépôt de matière fusible, le dépôt de matériau non mouillant (48) sur le deuxième élément (12) muni de zones mouillantes (34a), une partie des zones mouillantes n'étant pas recouverte de matériau non mouillant, de sorte que la matière fusible (44) est déposée au niveau de la partie non recouverte des zones mouillantes.

15. Procédé selon la revendication 14 dans lequel le dépôt de matériau non mouillant comprend :
- le dépôt d'une couche sacrificielle (50) ;
- la gravure de la couche de matériau non mouillant (48) au niveau des parties de zones mouillantes (34a).

16. Procédé selon la revendication 14 ou 15 comprenant le retrait de la couche non mouillante (48) avant le scellement par brasage.

17. Procédé selon l'une des revendications 10 à 16 tel que le deuxième élément (12) comprend au moins un sous élément (28) et qu'une partie de la première matière fusible est déposée autour dudit sous élément, de sorte que ledit sous élément (28) sera situé dans un passage délimité par des parois (24) de première matière fusible partiellement fondue.

18. Procédé selon l'une des revendications 10 à 17 tel que le deuxième élément (12) comprend au moins un sous élément (30) et qu'une partie de la première matière fusible est déposée sur une partie dudit sous élément, de sorte que ledit sous élément (30) constituera le fond du trou délimité par des parois (26) de première matière fusible fondue.

19. Procédé selon l'une des revendications 17 ou 18 comprenant la mise en place, après le scellement et la création du passage, d'une connexion d'au moins un sous élément (28, 30), ladite connexion passant par le passage.

20. Procédé selon la revendication 19 comprenant le dépôt d'une troisième matière fusible (54) sur un sous élément connecté, la troisième matière fusible assurant la connexion.

21. Procédé selon la revendication 20 dans lequel la troisième matière fusible (54) a un point de fusion inférieur à la première matière fusible (52).

22. Procédé selon l'une des revendications 10 à 21 dans lequel les premier et/ou deuxième éléments (12, 14) sont choisis parmi : un capot, un substrat, un capteur, un composant électronique, un composant optoélectronique, un actionneur.

## Claims

1. A microtechnological device (10) comprising at least one hermetically sealed cavity (16, 36), this hermetically sealed cavity being delimited by at least one sealing bead (18) and two sides made up by a first member (14) and a second member (12), and by at least one sealed wall of at least one passage delimited by the inner face of the second member (12), a hole (20, 22) in the first member (14) and said wall, which is in a meltable material (24, 26, 34) brazed on wetting areas of the first member and of the second member.

2. The device according to claim 1 comprising at least one sub-member (28, 30) positioned on the second member (12) and partly at least in the passage delimited by the inner face of the second member (12), said hole (20, 22) in the first member (14) and said wall.

3. The device according to claim 2 wherein at least one of said sub-members (28, 30) has an outward connection (46, 54, 60) passing through the passage.

4. The device according to claim 3, the connection of which is effected via a meltable ball (46, 54).

5. The device according to claim 4 wherein the meltable ball for the connection (46, 54) consists of the same material as the meltable material wall(s) (24, 26, 34).

6. The device according to any of claims 1 to 5, further comprising at least one component (2) in at least one of said hermetically sealed cavities (16, 36).

7. The device according to any of claims 1 to 6, the first and/or second members (12, 14) of which are selected from a substrate, a non-rigid substrate, a cap, a sensor, an electronic component, an optoelectronic component, an actuator.

8. The device according to any of claims 1 to 7, including a plurality of sealed walls, corresponding to a plurality of passages, each being delimited by the inner face of the second member, a hole (20, 22) in the first member (14) and one or several walls.

9. A module comprising a plurality of devices according to any of claims 1 to 8.

10. A method for making a microtechnological device including a first and second member comprising at least one passage with sealed walls, comprising the steps of:
- placing on said second member (12) wetting areas (34a), at least partly intended for making sealed walls (24, 26) of said passage;
- depositing on the wetting areas (34a) a first meltable material (52) and a second meltable material;
- positioning said first member (14) above the first meltable material, the second meltable material and the second member (12);
- sealing by brazing the assembly formed by both members (12, 14), the first meltable material (52) and the second meltable material so that at least one sealed space is created, delimited by both members (12, 14) and at least one first meltable material wall (24, 26) and that a hermetically sealed cavity is delimited by at least one sealing bead (18) in a second meltable material and two sides made up by the first member (14) and the second member (12), and at least one first meltable material wall,
- creating at least one hole (20, 22) in the first member (14) facing at least one sealed space defined by the first meltable material walls (24, 26) in order to obtain the passage with sealed walls.

11. A method for making a microtechnological device including a first and a second member and comprising at least one passage with the sealed walls, comprising the steps of:
- placing on said second member (12) wetting areas (34a), at least partly intended for making sealed walls (24, 26) of said passage;
- depositing on the wetting areas (34a) a first meltable material (52) and a second meltable material;
- positioning said first member (14) above the first meltable material (52), second meltable material and the second member (12), the first member (14) comprising at least one hole (20, 22) opening out;
- sealing by brazing the assembly formed by both members (12, 14) and the first meltable material (52) and the second meltable material so that the passage delimited by the opening hole (20, 22) of the first member (14), the second member (12) and at least one first meltable material wall (24, 26) has a sealed wall, and that a hermetically sealed cavity is delimited by at least one sealing bead (18) in a second meltable material and two sides made up by the first member (14) and the second member (12), and at least one first meltable material wall.

12. The method according to any of claims 10 or 11, wherein the first meltable material is identical with the second meltable material.

13. The method according to any of claims 10 to 12, wherein the meltable material deposition is localized deposition of a meltable alloy followed by the formation of meltable material balls by melting.

14. The method according to claim 13 comprising, prior to the deposition of meltable material, the deposition of non-wetting material (48) on the second member (12) provided with wetting areas (34a), one portion of the wetting areas not being covered with a non-wetting material, so that the meltable material (44) is deposited at the non-covered portion of the wetting areas.

15. The method according to claim 14, wherein the deposition of non-wetting material comprises:
- the deposition of a sacrificial layer (50);
- the etching of the non-wetting material layer (48) at the portions of wetting areas (34a).

16. The method according to claim 14 or 15 comprising the withdrawal of the non-wetting layer (48) before sealing by brazing.

17. The method according to any of claims 10 to 16, such that the second member (12) comprises at least one sub-member (28) and that a portion of the first meltable material is deposited around said sub-member, so that said sub-member (28) will be located in a passage delimited by walls (24) of partly melted first meltable material.

18. The method according to any of claims 10 to 17, such that the second member (12) comprises at least one sub-member (30) and that a portion of the first meltable material is deposited on a portion of said sub-member, so that said sub-member (30) will form the bottom of the hole delimited by walls (26) of melted first meltable material.

19. The method according to any of claims 17 or 18, comprising the placement, after sealing and creating the passage, of a connection of at least one sub-member (28, 30), said connection passing through the passage.

20. The method according to claim 19, comprising the deposition of a third meltable material (54) on a connected sub-member, the third meltable material providing the connection.

21. The method according to claim 20, wherein the third meltable material 54) has a melting point below that of the first meltable material (52).

22. The method according to any of claims 10 to 21, wherein the first and/or second members (12, 14) are selected from: a cap, a substrate, a sensor, an electronic component, an optoelectronic component, an actuator.

## Patentansprüche

1. Mikrotechnische Vorrichtung (10) mit wenigstens einem hermetisch dichten Hohlraum (16, 36), wobei dieser hermetisch dichte Hohlraum begrenzt ist durch wenigstens eine Versiegelungsnaht (18) und zwei Seiten, gebildet durch ein erstes Element (14) und ein zweites Element (12), und durch wenigstens eine dichte Wand, von wenigstens einer Durchführung, begrenzt durch die Innenseite des zweiten Elements (12), ein Loch (20, 22) in dem ersten Element (14) und der genannten Wand, die aus auf Netzungszonen des ersten Elements und des zweiten Elements gelötetem schmelzbarem Material (24, 26, 34) ist.

2. Vorrichtung nach Anspruch 1 mit wenigstens einem Unterelement (28, 39), positioniert auf dem zweiten Element (12) und zumindest teilweise in der Durchführung, begrenzt durch die Innenseite des zweiten Elements (12), das Loch (20, 22) in dem ersten Element (14) und die genannte Wand.

3. Vorrichtung nach Anspruch 2, bei der wenigstens eines der genannten Unterelemente (28, 30) eine die Durchführung passierende Verbindung (46, 54, 60) nach außen besitzt.

4. Vorrichtung nach Anspruch 3, deren Verbindung mittels einer schmelzbaren Kugel (46, 54) realisiert wird.

5. Vorrichtung nach Anspruch 4, bei der die schmelzbare Kugel für die Verbindung (46, 54) aus dem gleichen Material ist wie die Wand oder Wände aus schmelzbarem Material (24, 26, 34).

6. Vorrichtung nach einem der Ansprüche 1 bis 5, umfassend wenigstens eine Komponente (2) in wenigstens einem der genannten hermetisch dichten Hohlräume (16, 36).

7. Vorrichtung nach einem der Ansprüche 1 bis 6, deren erstes und/oder zweites Element (12, 14) ausgewählt werden zwischen einem Substrat, einem unsteifen Substrat, einem Deckel, einem Sensor, einer elektronischen Komponente, einer optoelektronischen Komponente, einem Aktor.

8. Vorrichtung nach einem der Ansprüche 1 bis 7 mit einer Vielzahl von dichten Wänden, entsprechend einer Vielzahl von Durchführungen, jede begrenzt durch die innenseite des zweiten Elements, ein Loch (20, 22) in dem ersten Element (14) und eine oder mehrere Wände.

9. Modul mit einer Vielzahl von Vorrichtungen nach einem der Ansprüche 1 bis 8.

10. Verfahren zur Herstellung einer mikroelektronischen Vorrichtung mit einem ersten und einem zweiten Element und wenigstens einer Durchführung mit dichten Wände, die folgenden Schritte umfassend:
- Platzieren von Netzungszonen (34a) auf dem genannten zweiten Element (12), zumindest teilweise dazu bestimmt, dichte Wände (24, 26) der genannten Durchführung zu bilden;
- Abscheiden von erstem schmelzbarem Material (52) und von zweitem schmelzbarem Material auf Netzungszonen (34a);
- Positionieren des genannten ersten Elements (14) über dem ersten schmelzbaren Material, dem zweiten schmelzbaren Material und dem zweiten Element (12);
- Versiegeln des durch die beiden Elemente (12, 14), dem ersten schmelzbaren Material (52) und dem zweiten schmelzbaren Material gebildeten Ganzen, so dass sich wenigstens ein dichter Raum bildet, begrenzt durch die beiden Elemente (12, 14) und wenigstens eine Wand aus dem ersten schmelzbaren Material (24, 26), und dass ein hermetisch dichter Hohlraum abgegrenzt wird durch wenigstens eine Versiegelungsnaht (18) aus dem zweiten schmelzbaren Material und zwei Seiten, gebildet durch das erste Element (14) und das zweite Element (12), und wenigstens eine Wand aus dem ersten schmelzbaren Material,
- Herstellen wenigstens eines Lochs (20, 22) in dem ersten Element (14) gegenüber wenigstens eines dichten Raums, definiert durch die Wände aus dem ersten schmelzbaren Material (24, 26), um die Durchführung mit dichten Wänden zu erhalten,

11. Verfahren zur Herstellung einer mikroelektronischen Vorrichtung mit einem ersten und einem zweiten Element und wenigstens einer Durchführung mit dichten Wänden, die folgenden Schritte umfassend:
- Platzieren von Netzungszonen (34a) auf dem genannten zweiten Element (12), zumindest teilweise dazu bestimmt, dichte Wände (24, 26) der genannten Durchführung zu bilden;
- Abscheiden von erstem schmelzbarem Material (52) und von zweitem schmelzbarem Material auf Netzungszonen;
- Positionieren des genannten ersten Elements (14) über dem ersten schmelzbare Material (52), dem zweiten schmelzbaren Material und dem zweiten Element (12), wobei das erste Element (14) wenigstens ein mündende Loch (20, 22) umfasst;
- Versiegeln des durch die beiden Elemente (12, 14), dem ersten schmelzbaren Material (52) und dem zweiten schmelzbaren Material gebildeten Ganzen, so dass die Durchführung, abgegrenzt durch das mündende Loch (20, 26) des ersten Elements (14), das zweite Element (12) und wenigstens eine Wand aus dem ersten schmelzbaren Material (24, 26), eine dichte Wand ist, und dass ein hermetisch dichter Hohlraum abgegrenzt wird durch wenigstens eine Versiegelungsnaht (18) aus dem zweiten schmelzbaren Material und zwei Seiten, gebildet durch das erste Element (14) und das zweite Element (12), und wenigstens eine Wand aus dem ersten schmelzbaren Material.

12. Verfahren nach einem der Ansprüche 10 oder 11, bei dem das erste schmelzbare Material identisch ist mit dem zweiten schmelzbaren Material.

13. Verfahren nach einem der Ansprüche 10 bis 12, bei dem das Aufbringen des schmelzbaren Materials ein lokalisiertes Aufbringen von schmelzbarer Legierung ist, gefolgt von der Bildung von Kugeln aus schmelzbarem Material durch Schmelzen.

14. Verfahren nach Anspruch 13, umfassend - vor dem Aufbringen von schmelzbarem Material -, das Abscheiden von nicht netzendem Material (48) auf dem zweiten Element (12), versehen mit Netzungszonen (34a), wobei ein Teil der Netzungszonen nicht mit nicht netzendem Materials überzogen ist, so dass das schmelzbare Material in dem nicht-überzogenen Teil der Netzungszonen aufgebracht wird.

15. Verfahren nach Anspruch 14, bei dem das Abscheiden des nicht netzenden Materials umfasst:
- das Abscheiden einer Opferschicht (50);
- das Ätzen der Schicht aus nicht netzendem Material (48) in den Netzungszonenteilen (34a).

16. Verfahren nach Anspruch 14 oder 15, umfassend das Entfernen der nichtnetzenden Schicht (48) vor dem Versiegeln durch Lötung.

17. Verfahren nach einem der Ansprüche 10 bis 16, derartig, dass das zweite Element (12) wenigstens ein Unterelement (28) umfasst und dass ein Teil des ersten schmelzbaren Materials um das genannte Unterelement herum abgeschieden wird, so dass das genannte Unterelement (28) sich in einer durch Wände (24) aus partiell geschmolzenem erstem Material abgegrenzten Durchführung befindet.

18. Verfahren nach einem der Ansprüche 10 bis 17, derartig, dass das zweite Element (12) wenigstens ein Unterelement (30) umfasst und dass ein Teil des ersten schmelzbaren Materials auf einem Teil des genannten Unterelements abgeschieden wird, so dass das genannte Unterelement (30) den Boden des durch Wände (26) aus erstem schmelzbarem Material abgegrenzten Lochs bildet.

19. Verfahren nach einem der Ansprüche 17 oder 18, umfassend - nach der Versiegelung und der Realisierung der Durchführung - das Herstellen eines Anschlusses von wenigstens einem Unterelement (28, 30), wobei der genannte Anschluss die Durchführung passiert.

20. Verfahren nach Anschluss 19, umfassend das Abscheiden eines dritten schmelzbaren Materials (54) auf einem angeschlossenen Unterelement, wobei das dritte schmelzbare Material den Anschluss gewährleistet.

21. Verfahren nach Anschluss 20, bei dem das dritte schmelzbare Material (54) einen niedrigeren Schmelzpunkt hat als das erste schmelzbare Material (52).

22. Verfahren nach einem der Ansprüche 10 bis 21, bei dem das erste und/oder zweite Element (12, 14) ausgewählt werden unter: einem Deckel, einem Substrat, einem Sensor, einer elektronischen Komponente, einer optoelektronischen Komponente, einem Aktor.
